(19) Europäisches Patentamt
European Patent Office
Office européen des brevets

(11) Publication number: **0 185 423**
**A1**

(12) **EUROPEAN PATENT APPLICATION**

(21) Application number: 85202013.0

(22) Date of filing: 04.12.85

(51) Int. Cl.⁴: C 08 F 2/50
G 03 C 1/68

(30) Priority: 06.12.84 NL 8403706

(43) Date of publication of application: 25.06.86 Bulletin 86/26

(84) Designated Contracting States: BE DE FR GB IT NL SE

(71) Applicant: DSM RESINS BV
Ceintuurbaan 5
NL-8022 AW Zwolle(NL)

(72) Inventor: de Koning, Adrianus Johannes
Nunspeethoeve 26
NL-3137 SH Vlaardingen(NL)

(74) Representative: Leherte, Georges Maurice Lucien Marie et al,
Octrooibureau DSM P.O.Box 9
NL-6160 MA Geleen(NL)

(54) **Photopolymerizable composition and a photo-initiator system.**

(57) The invention relates to photopolymerizable compositions comprising one or more polymerizable ethylenically unsaturated compounds and a photo-initiator system comprising a diketon: A-(C=O)-(C=O)-A' (A and A' are aromatic hydrocarbon groups), and a reducing agent $N-R_1R_2R_3$ ($R_1$, $R_2$ and $R_3$ are hydrogen, hydrocarbon, substituted hydrocarbon or aromatic, at least one R bears an α-H), and is characterized in that 0.001 1 % (wt) of a polyhalogen-containing compound is added to the photo-initiator system, while 0.001 1 % (wt) photo initiator is used.

EP 0 185 423 A1

PHOTOPOLYMERIZABLE COMPOSITION AND A PHOTO-INITIATOR SYSTEM

The invention relates to a photopolymerizable composition comprising one or more polymerizable ethylenically unsaturated compounds and a suitable photo initiator system.

Under the influence of radiation energy - both ultraviolet and visible light - it is possible to induce the polymerization of ethylenically unsaturated radically polymerizable monomers. To this end as a rule photo-initiators are used which are converted to a chemically reactive excited state either through direct light absorption or through the transfer of energy of a photochemically excited sensitizer. The photo-initiators used in actual practice for initiating radical polymerizations can be divided into two main groups:

I photo-initiators generating initiator radicals through intramolecular cleavage (photofragmentation), such as benzoin ethers (DE-A 1694149), benzil ketals (US 3715293) and acylphosphine oxides (EP-A 7086),

II photo-initiators producing initiator radicals through intermolecular hydrogen abstraction; in these redox systems the presence of a hydrogen donor as co-initiator is required. Example: (di)ketones + reducing agent (US 4071424).

For the photopolymerization to be efficient it is necessary for the absorption band of the photo-initiator or photosensitizer to properly correspond with the main emission band of the source of radiation applied.

It has been tried to find an efficient photo-initiator system for curing (reinforced) polyester layers having a thickness of 3 to 25 mm. The technical-grade photo-initiators that are used have been found unsuitable for this purpose.

The benzoin ethers and related compounds are active only in the UV region of the spectrum. Using this light it is impossible to

cure substrates thicker than about 3 mm owing to the strong absorption of the UV radiation by both the resin and the glass fibre reinforcement that may be present.

Moreover, the disadvantage of UV light is that it is harmful to the eyes and to the skin so that, for the protection of the processors' health, extra safety precautions must be taken.

Under normal circumstances visible light does not have any harmful effects on health. Using the photo-initiators active in the spectral range between 400 and 500 nm, for instance redox systems, as described in the Netherlands patent 165570, it is possible theoretically to cure thick reinforced substrates. In actual practice, however, it has been found that these photo-initiators are not suitable for curing thick reinforced substrates by means of visible light.

According to the said Netherlands patent 165570 (equivalent to US-A 4071424) the photopolymerizable composition comprises a photo-initiator system containing (a) as photo-initiator a compound having the formula

$$A_1 - \underset{\underset{O}{\parallel}}{C} - \underset{\underset{O}{\parallel}}{C} - A_2$$

where groups $A_1$ and $A_2$, which may be the same or different, represent an aromatic hydrocarbon group or substituted hydrocarbon group and groups $A_1$ and $A_2$ may further be linked together by a direct link or by a divalent hydrocarbon group, or may together form a fused aromatic ring system, and (b) as reducing agent capable of reducing the photo-initiator when it is in an excited state one or more compounds having the formula

$$R_2 - \overset{\overset{R_1}{|}}{N} - R_3$$

where groups $R_1$, $R_2$ and $R_3$, which may be the same or different, represent a hydrogen atom, hydrocarbon group or substituted hydrocarbon group and where two of the groups $R_1$, $R_2$ and $R_3$ may further form, together with N, a cyclic ring system, where not more than two of the groups $R_1$, $R_2$ and $R_3$ are hydrogen atoms and, if N is linked by a direct link to an aromatic group, at least one of the other groups $R_1$,

0185423

$R_2$ and $R_3$ has a N-linked-CH-group.

The process according to the invention proceeds from such a composition and is characterized in that 0.001-1 % (wt) of a polyhalogen-containing compound is added to the photo-initiator system, while 0.001-1 % (wt) photo-initiator is used.

According to a preferred embodiment of the invention the polyhalogen-containing compound used is an aliphatic compound. The aliphatic compound preferably contains at least one carbon atom containing two or more halogen atoms. In this connection preference is given to carbon tetrachloride, hexachloroethane, heptachloropropane and octachloropropane.

According to a further preferred embodiment of the invention, the polyhalogen-containing compound is a cycloaliphatic compound. The cycloaliphatic compound preferably contains at least one carbon atom - forming part of the ring system - which contains two halogen atoms. In this connection preference is given to heptachlorocyclohexane. According to another preferred embodiment of the invention the polyhalogen-containing compound is an aromatic compound. The aromatic compound preferably contains at least two carbon atoms containing one halogen atom. In this connection preference is given to hexachlorobenzene.

According to yet another preferred embodiment of the invention the polyhalogen-containing compound is a halogenalkyl-cycloaliphatic and/or halogenalkyl-aromatic compound in which at least one carbon atom of the alkyl part contains two or more halogen atoms.

The molar ratio between the photo-initiator and the polyhalogen-containing compound is preferably between 5 : 1 and 1 : 5, most preferably about 1 : 1.

The photo-initiator with the formula

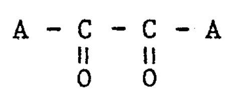

that can be used are notably benzil compounds, in which the two groups A are phenyl, $\alpha$-naphthyl and $\beta$-naphthyl, i.e. $\alpha$-diketones in which both groups A are fused aromatic groups, and p-tolil an $\alpha$-diketone, in which the groups A are arylalkyl groups, a furil, for instance

2,2'-furil, phenanthrenequinone, an α-diketone in which A represents a phenyl group and the two groups A are linked by a direct link ortho in respect of the keto groups, acenaphthaquinone and an α-diketone in which the groups A are substituted by non-hydrocarbon groups, for instance p,p'-dimethoxybenzil, p,p'-dichlorobenzil and p-nitrobenzil.

The reducing agents having the formula

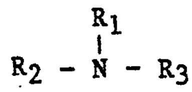

are preferably free from aryl groups linked by a direct link to the nitrogen. If R represents a hydrocarbon group, it may be an alkyl, cycloalkyl or alkyl aryl group, specifically an alkyl group with 1-10 carbon atoms.

Suitable reducing agents in which one or more of the groups R is a (substituted) aliphatic hydrocarbon group are propylamine, n-butylamine, pentylamine, hexylamine, dimethylamine, diethylamine, dipropylamine, di-n-butylamine, dipentylamine, trimethylamine, triethylamine, tripropylamine, tri-n-butylamine, tripentylamine, dimethylamino-ethyl methacrylate and long chain fatty amines, for instance $C_{18}H_{37}NME_2$.

Examples of reducing agents containing aromatic groups are N,N-dimethyl aniline and N-methyl diphenylamine. Of these compounds preference is given to the use of dimethylamino-ethyl methacrylate, triethylamine, N,N dimethylbenzylamine and tri(isopropanol)amine.

Examples of a reducing agent with the formula

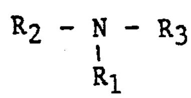

where at least one of the groups $R_1$, $R_2$ and $R_3$ is a substituted hydrocarbon group are diamines having the structural formula

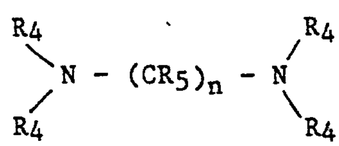

where n is an integer of at least 2 and the groups $R_4$ and $R_5$, which may be the same or different, are hydrogen atoms or hydrocarbon groups such as alky` groups. By preference, $R_5$ is hydrogen. The reducing agent may be, for instance, ethylene-diamine, trimethylenediamine,

tetramethylenediamine, pentamethylenediamine or hexamethylenediamine, or N-hydrocarbon, such as N-akyl derivatives thereof.

Examples of reducing agents having the formula

$$R_2 - \overset{\displaystyle R_1 \atop |}{N} - R_3$$

where the nitrogen forms part of a cyclic ring system include piperidine and N-hydrocarbon, such as N-alkyl derivatives of piperidine.

The concentration of the reducing agents having the formula

$$R_2 - \overset{\displaystyle R_1 \atop |}{N} - R_3$$

in the photosensitive composition is generally between 0.001 and 10 % (wt) calculated on the polymerizable ethylenically unsaturated compound. The reducing agent, if not containing any aromatic groups, is preferably present in the photopolymerizable composition in a concentration of 1-5 % (wt) calculated on the polymerizable ethylenically unsaturated compound(s).

Preference is given to the combination in which the photoinitiator used is benzil or 4,4'dimethylbenzil, the reducing agent dimethylamino-ethyl methacrylate or N,N dimethylbenzylamine and the polyhalogen-containing compound carbon tetrachloride or heptachloropropane.

The ethylenically unsaturated compound is preferably an unsaturated polyester. This unsaturated polyester is generally composed of one or more aliphatic and/or cycloaliphatic monovalent, divalent and/or polyvalent alcohols and one or more aliphatic, cycloaliphatic and/or aromatic divalent or polyvalent carboxylic acids and, if so desired, monocarboxylic acids and/or esters derived therefrom. Examples of suitable alcohols are benzyl alcohol, ethylene glycol, propylene glycol, neopentyl glycol, hexane diol, dimethylcyclohexane, diethylene glycol, glycerol, trimethylolpropane, pentaerythritol and/or dipentaerythritol. Instead of or in addition to the alcohol compound(s) one or more epoxy compounds can be used, such as for instance ethylene oxide, propylene oxide and/or allylglycidyl ether. Examples of suitable di or polyvalent carboxylic acids are maleic acid, fumaric acid, itaconic acid, citraconic acid, malonic acid, succinic acid, glutaric acid, adipic acid, sebacic acid, tetrahydrophthalic acid, hexahydrophthalic acid, hexachloroendomethylene tetrahydrophthalic acid, dichlorophthalic acid, isophthalic acid, terephthalic acid and/or trimellitic acid. The carboxylic acid can be used also in the form of an anhydride, for instance maleic anhydride or phthalic anhydride.

The dicarboxylic acid component used is preferably the maleic anhydride, often in combination with isophthalic acid and/or orthophthalic acid. If so desired, the unsaturated polyester may also contain saturated or unsaturated monocarboxylic acids, such as synthetic and/or natural fatty acids with 2 to 36 carbon atoms or esters prepared from these carboxylic acids and polyvalent alcohols, such as glycerol.

Examples of suitable monocarboxylic acids are lauric acid, stearic acid, oleic acid, linoleic acid, benzoic acid, acrylic acid and/or methacrylic acid.

The polyester can be prepared in various ways, for instance by means of the melting process in which the reaction of the components and the evaporation of the water released in the reaction coincide. However, it is possible also to apply a solvent process with azeotropic removal of the water.

Other ethylenically unsaturated ester resins that can be used according to the process according to the invention are the so-called vinyl esters. These vinyl esters can be prepared by a reaction of an epoxy resin with an unsaturated carboxylic acid. Examples of such vinyl esters are the reaction products of 2 moles $\alpha,\beta$-ethylenically unsaturated acid, such as methacrylic acid or acrylic acid, with 1 mole of an epoxy polymer, such as the diglycidyl ether of 2,2-di(4-hydroxy-phenyl)propane and the diglycidyl ether of phenolformaldehyde resins.

Examples of suitable ethylenically unsaturated monomers serving as reactive solvent for the unsaturated polyester and vinyl esters are styrene, $\alpha$-methylstyrene, p-methylstyrene, vinyltoluene, divinylbenzene, dialylphthalate and acrylic acid or methacrylic acid (hydroxy)esters of alcohols with 1 to 12 carbon atoms, such as methanol, ethanol, propanol, butanol, ethylene glycol, propylene glycol, neopentyl glycol, butanediol, hexanediol, polyethylene glycol, glycerol, trimethylolethane, trimethylolpropane and pentaerythritol. Preference is given to the use of styrene. Suitable also are mixtures of monomers, particularly of styrene and other monomers.
The monomeric compound is usually present in the resin in an amount of 2 to 55 % calculated on the total amount.

The photopolymerizable resins can be stabilized with the customary inhibitors. Examples of such compounds are phenolic inhibitors such as (substituted) hydroquinone, benzoquinone, chloroxanil and nitrobenzene.

Certain UV stabilizers, too, can be added to the resin without having any effect on the photochemically induced curing, which takes place, after all, at the instigation of visible light. Examples of such compounds are the oxybenzophenone, salicylic acid esters and oxyphenylbenztriazoles.

The thickener for polyester resins may be oxides and hydroxides of, for instance, lithium, magnesium, calcium or zinc, or metal alcoholates of, for instance, magnesium, calcium, aluminium or titanium.

Fillers like aluminium trihydrate, quartz sand, glass powder, barium sulphate and lime can also be added to the resins. The powdery fillers, however, must be transparent to the light used for the photochemical curing (370-450) so that in thick layers, too, the polymerization proceeds well.

As reinforcing materials for unsaturated polyester and vinyl ester resins both inorganic and organic fibres are eligible. Examples of such materials are glass fibres, carbon fibres, polyesters and aromatic polyamides.

Lubricants such as metal stearates and polyethylene waxes can be added also to polyester resins.

Finally, mention is made of the low profile additives. A few examples of these shrink-resistant additives are, for instance, polystyrene, polyvinylacetate and polymethacrylate.

In addition to the photo-initiator system according to the

invention, thermally decomposing radical initiators may be added also in amounts of 0.01 to 2.0 % (wt). The curing of the shaped polyester article is usually promoted by these, but the pot life of the polyester resin, of course, will show a strong decrease. Examples of thermally decomposing initiators known in the art are peresters, such as tert. butylperoctoate and tert. butylperpivalate; percarbonates, such as bis-4-tert. butylcyclohexylperoxidicarbonate, diacyl peroxides, such as benzoyl peroxide; dialkylperoxides, such as di-tert. butylperoxides and dicumylperoxide; azo compounds, such as azodiisobutyronitrile; C-C unstable compounds, such as tetra-substituted dibenzyl compounds.

The photopolymerizable compositions according to the invention can be used during the processing of resin such as, for instance, lamination for the production of big articles, filament winding for the production of, for instance, tubes, pultrusion and dicontinuous moulding techniques.

The invention is further elucidated by means of the examples following hereinafter without, however, being limited thereto.

## Examples

In order to determine the activity of the light radiation curing system the temperature variation in the resin is observed during the irradiation. To this end a thermocouple connected to a recorder is placed in a glass cylinder with a diameter of 3 cm filled with 10 g polyester resin (thickness of resin layer 10 mm). In order to avoid loss of heat the resin-filled glass vessel is surrounded with polyurethane foam for the duration of the irradiation.

The source of radiation applied consists of a series of 5 40-watt fluorescent tubes in parallel having a wavelength maximum of 420 nm; the relative distances between the tubes are 10 cm. The distance from the tube system to the surface of the substrate is in all cases 20 cm.

The quantities that are measured are:

a. the maximum temperature acquired by the resin during the irradiation ($T_{max}$)

b. the time that passes from the beginning of the irradiation till the moment when the top temperature is reached ($t_{max}$)

c. the Barcol hardness (GYZj 934-1) on top as well as on the bottom of the cured article 3 hours after the irradiation was stopped. The irradiation is discontinued 5 minutes after reaching the maximum temperature.

Every experiment was made at least three times. The temperature of the resin at the beginning is in all cases 25 °C.

An average-reactive isophthalic acid polyester resin consisting of 39 % (wt) styrene and 61 % (wt) unsaturated polyester has been used. The acid number of the resin is 11-15 mg KOH/g.

Example I

In this example the efficiency of a few photo-initiator redox systems is the presence of halogenated hydrocarbon is tested. To the resin 0.4 % (wt) benzil (photo-initiator), 1.0 % (wt) reducing agent and an equimolar amount (in respect of benzil) of polyhalogen-containing compound are added. The results of these experiments are mentioned in the table below.

| reducing agent | polyhalogen-containing compound | $t_{max}$ (min) | $T_{max}$ (°C) | Barcol hardness above | below |
|---|---|---|---|---|---|
| a) dimethylaminoethyl-methacrylate* | | 14 | 140 | 33 | 34 |
| b) dimethylaminoethyl-methacrylate | carbon-tetrachloride | 13 | 146 | 35 | 38 |
| c) dimethylaminoethyl-methacrylate | heptachloro-propane | 13 | 147 | 34 | 38 |
| d) N,N,N',N'-tetra-methylenediamine* | | 10 | 142 | 33 | 32 |
| e) N,N,N',N'-tetra-methylenediamine | carbon-tetrachloride | 10 | 151 | 35 | 39 |
| f) N,N,N',N'-tetra-methylenediamine | heptachloro-propane | 10 | 150 | 35 | 38 |

* Comparative examples

Owing to the addition of the halogenated hydrocarbon the Barcol hardness on the bottom of the irradiated article has increased.

Example II

Rectangular laminates having a surface area of 375 $cm^2$ have been made on the basis of the polyester resin mentioned under example 1 and glass mats (chopped strand mat 450 $g/m^2$). The glass content of the laminates is about 33 %. Layers with thicknesses of 5, 10 and 20 mm have been cured. The source of radiation is again the set of five 40-Watt fluorescent tubes placed in parallel with a wavelength maximum of 420 nm. The distance between the laminate and the tubes is 20 cm. The substrate for the laminate is a wooden plate with a thickness of 1 cm.

The photo-initiator system used is benzil (0.4 % (wt) calculated on the polyeter resin), N,N,N',N'-tetramethylethylenediamine (1 % (wt)) and carbontetrachloride (0.3 % (wt)).

| laminate thickness (cm) | $t_{max}$ (min) | $T_{max}$ (°C) | period of irradiation (min.) | Barcol hardness above | below |
|---|---|---|---|---|---|
| 0.5 | 9.5 | 84 | 15 | 37 | 44 |
| 1.0 | 12.5 | 117 | 20 | 40 | 47 |
| 2.0 | 20 | 105 | 60 | 42 | 46 |

This example shows that with the said photo-initiator system thick glass fibre-reinforced polyesters are cured efficiently.

# CLAIMS

1. Photopolymerizable composition comprising one or more polymerizable ethylenically unsaturated compounds and a photo-initiator system containing a compound having the formula

$$A_1 - \underset{\underset{O}{\|}}{C} - \underset{\underset{O}{\|}}{C} - A_2$$

where the groups $A_1$ and $A_2$, which may be the same or different, represent an aromatic hydrocarbon or substituted hydrocarbon group and the groups $A_1$ and $A_2$ may further be linked together by a direct link or by a divalent hydrocarbon group, or may together form a fused aromatic ring system, and (b) as reducing agent capable of reducing the photo-initiator when it is in an excited state one or more compounds having the formula

$$R_2 - \overset{\overset{R_1}{|}}{N} - R_3$$

where the groups $R_1$, $R_2$ and $R_3$, which may be the same or different, represent a hydrogen atom, hydrocarbon group or substituted hydrocarbon group and where two of the groups $R_1$, $R_2$ and $R_3$ may further form, together with N, a cyclic ring system where not more than two of the groups $R_1$, $R_2$ and $R_3$ are hydrogen atoms and, if N is linked by a direct link to an aromatic group, at least one of the other groups $R_1$, $R_2$ and $R_3$ has a N-linked -CH- group, the composition being characterized in that 0.001-1 % (wt) of a polyhalogen-containing compound is added to the photo-initiator system, while 0.001-1 % (wt) photo-initiator is used.

2. Photopolymerizable composition according to claim 1, characterized in that the polyhalogen-containing compound applied is an aliphatic compound.

3. Photopolymerizable composition according to claim 2, characterized in that the aliphatic compound contains at least one carbon atom with two or more halogen atoms.

4. Photopolymerizable composition according to claim 3, characterized in that the aliphatic compound used is carbon tetrachloride, hexachloro-ethane, heptachloropropane or octachloropropane.
5. Photopolymerizable composition according to claim 1, characterized in that the polyhalogen-containing compound is a cycloaliphatic compound.
6. Photopolymerizable composition according to claim 5, characterized in that the cycloaliphatic compound contains at least one carbon atom - forming part of the ring system - with two halogen atoms.
7. Photopolymerizable composition according to claim 6, characterized in that the cycloaliphatic compound used is heptachlorocyclohexane.
8. Photopolymerizable composition according to claim 1, characterized in that the polyhalogen-containing compound used is an aromatic compound.
9. Photopolymerizable composition according to claim 8, characterized in that the aromatic compound contains at least two carbon atoms with one halogen atom.
10. Photopolymerizable composition according to claim 9, characterized in that the aromatic compound used is hexachlorobenzene.
11. Photopolymerizable composition according to claim 1, characterized in that the polyhalogen-containing compound used is a halogenalkyl-cyclo-aliphatic and/or halogenalkyl-aromatic compound in which at least one carbon atom of the alkyl part contains two or more halogen atoms.
12. Photopolymerizable composition according to claim 1-11, characterized in that the molar ratio between the photo-initiator and the polyhalogen-containing compound is between 5 : 1 and 1 : 5.
13. Photopolymerizable composition according to claim 12, characterizxed in that the role ratio between the photo-initiator and the polyhalogen-containing compound is about 1 : 1.
14. Photopolymerizable composition according to claim 1, characterized in that the photo-initiator used is benzil or 4,4'-dimethylbenzil, the reducing agent dimethylaminoethyl methacrylate or N,N-dimethylbenzylamine and the polyhalogen-containing compound carbon tetrachloride or heptachloropropane.

15. Photo-initiator system containing as photo-initiator a compound having the formula

$$A_1 - \underset{\overset{\|}{O}}{C} - \underset{\overset{\|}{O}}{C} - A_2$$

where the groups $A_1$ and $A_2$, which may be the same or different, represent an aromatic hydrocarbon or substituted hydrocarbon group and the groups $A_1$ and $A_2$ may further be linked together by a direct link or by a divalent hydrocarbon group, or may together form a fused aromatic ring system and (b) as reducing agent capable of reducing the photo-initiator when it is in an excited state one or more compounds having the formula

$$R_2 - \overset{\overset{R_1}{|}}{N} - R_3$$

where the groups $R_1$, $R_2$ and $R_3$, which may be the same or different, represent a hydrogen atom, hydrocarbon group, substituted hydrocarbon group and where two of the groups $R_1$, $R_2$ and $R_3$ may further form, together with N, a cyclic ring system, in which not more than two of the groups $R_1$, $R_2$ and $R_3$ are hydrogen atoms and, if N is linked by a direct link to an aromatic group, at least one of the other groups $R_1$, $R_2$ and $R_3$ has an N-linked -CH- group, the system being characterized in that 0.001-1 % (wt) of a polyhalogen-containing compound is added to the photo-initiator system.

European Patent Office

**EUROPEAN SEARCH REPORT**

0185423

Application number

EP 85 20 2013

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | US-A-3 966 573 (A.J. BEAN)<br>* Claim 1 *<br>--- | 1-15 | C 08 F 2/50<br>G 03 C 1/68 |
| X | FR-A-2 216 304 (SUN CHEMICAL CORP.)<br>* Claims 1,2,4,7 *<br>--- | 1-15 | |
| D,X | US-A-4 071 424 (E.C. DART et al.)<br>* Claim 1 *<br>----- | 1-15 | |
| | | | TECHNICAL FIELDS SEARCHED (Int. Cl.4) |
| | | | C 08 F<br>G 03 C |

The present search report has been drawn up for all claims

| Place of search | Date of completion of the search | Examiner |
|---|---|---|
| THE HAGUE | 24-03-1986 | CAUWENBERG C.L.M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82